# EUROPÄISCHE PATENTSCHRIFT

(11) **EP 3 663 783 B1**
(45) Veröffentlichungstag und Bekanntmachung des Hinweises auf die Patenterteilung: **04.01.2023**
(21) Anmeldenummer: 19209892.9
(22) Anmeldetag: 19.11.2019
(51) Int. Cl.: G01R 31/52, G01R 15/20, G01R 15/18, G01R 31/08

(54) **MAGNETFELD-MESSVORRICHTUNG UND VERFAHREN ZUR ERFASSUNG EINES LOKALISIERUNGSSTROMS IN EINEM VERZWEIGTEN WECHSELSTROM-STROMVERSORGUNGSSYSTEM**
MAGNETIC FIELD MEASURING DEVICE AND METHOD FOR DETECTING A LOCATION CURRENT IN A BRANCHED AC POWER SUPPLY SYSTEM
DISPOSITIF DE MESURE DE CHAMP MAGNÉTIQUE ET PROCÉDÉ DE DÉTECTION D'UN COURANT DE LOCALISATION DANS UN SYSTÈME RAMIFIÉ D'ALIMENTATION ÉLECTRIQUE À COURANT ALTERNATIF

(30) Priorität: 03.12.2018 DE 102018130690
(43) Veröffentlichungstag der Anmeldung: 10.06.2020
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- EP-A1- 2 905 627
- DE-A1-102015 214 615
- US-A- 4 278 940
- US-A- 5 075 628

## Beschreibung

Die Erfindung betrifft eine Magnetfeld-Messvorrichtung und ein Verfahren zur Erfassung eines Lokalisierungsstroms in einem verzweigten Wechselstrom-Stromversorgungssystem, wobei in einem zu prüfenden Leitungsabschnitt des Wechselstrom-Stromversorgungssystems ein Laststrom mit einer Netzfrequenz fließt und der Lokalisierungsstrom eine Frequenz unterhalb der Netzfrequenz aufweist.

Des Weiteren betrifft die Erfindung eine Verwendung der erfindungsgemäßen Magnetfeld-Messvorrichtung als Vorrichtung zur Lokalisierungsstrom-Erfassung für ein Isolationsfehlerlokalisierungssystem.

Im Folgenden werden an dem Beispiel eines ungeerdeten Stromversorgungssystems zunächst die Bedeutung eines Isolationsfehlerlokalisierungssystems und die daraus resultierende Notwendigkeit einer Erfassung eines Lokalisierungsstroms aufgezeigt. Allerdings ist die Erfindung nicht auf den Einsatz in ungeerdeten Stromversorgungssystemen beschränkt, sondern kann auch allgemein in einem hochohmig oder niederohmig widerstandsgeerdeten Stromversorgungssystem überall dort Anwendung finden, wo die Erfassung eines Lokalisierungsstromes erforderlich ist.

Bei erhöhten Anforderungen an die Betriebs-, Brand- und Berührungssicherheit kommt die Netzform eines ungeerdeten Stromversorgungssystems zum Einsatz, die auch als isoliertes Netz (frz. Isolé Terre - IT) oder als IT-Stromversorgungssystem bezeichnet wird.

Bei dieser Art des Stromversorgungssystems sind die aktiven Teile des Netzes von dem Erdpotenzial getrennt - gegen Erde isoliert - oder über eine hochohmige Impedanz mit Erde verbunden.

Der Vorteil dieser Netze liegt darin, dass bei einem Isolationsfehler (erster Fehler), wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Fehlerstromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) muss daher ständig überwacht werden, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Unter der Voraussetzung, dass der Isolationszustand des ungeerdeten Stromversorgungssystems kontinuierlich von einem Isolationsüberwachungsgerät (Insulation Monitoring Device - IMD) überwacht wird, kann das ungeerdete Stromversorgungssystem auch bei einem aufgetretenen ersten Fehler ohne vorgeschriebene Zeitlimitierung weiterbetrieben werden, jedoch gilt die Empfehlung, den ersten Fehler so schnell wie praktisch möglich zu beseitigen.

Um die Anforderung nach der schnellen Beseitigung des ersten Fehlers zu erfüllen, stellt insbesondere in ausgedehnten, weit verzweigten ungeerdeten Stromversorgungssystemen der Einsatz eines Isolationsfehlerlokalisierungssystems/Isolationsfehlersucheinrichtung (Insulation Fault Location System - IFLS) - wie in der Produktnorm IEC 61557-9 beschrieben - den Stand der Technik dar.

Das Isolationsfehlerlokalisierungssystem umfasst im Wesentlichen einen Prüfstromgenerator und mehrere meist als Messstromwandler ausgeführte Prüfstromsensoren, die zur Auswertung der Messsignale mit einer Auswerteeinheit des Isolationsfehlerlokalisierungssystems verbunden sind.

Ist in dem ungeerdeten Stromversorgungssystem ein erster Isolationsfehler von dem Isolationsüberwachungsgerät erkannt worden, startet die Isolationsfehlersuche, indem der Prüfstromgenerator einen Prüfstrom erzeugt und diesen als Lokalisierungsstrom an zentraler Stelle in das ungeerdete Stromversorgungssystem zwischen einem oder mehreren aktiven Leitern und Erde einspeist. Es entsteht ein geschlossener Prüfstromkreis, in dem der Lokalisierungsstrom von dem Prüfstromgenerator über die spannungsführenden aktiven Leiter, den Isolationsfehler und über eine Erdverbindung zurück zu dem Prüfstromgenerator fließt.

Die Lokalisierung des Fehlerortes erfolgt über eine Detektion des Lokalisierungsstroms in dem ungeerdeten Stromversorgungssystem durch die Prüfstromsensoren, wobei jedem zu überwachenden Leitungsabschnitt ein Prüfstromsensor fest zugeordnet ist und somit der Pfad des Prüfstroms (Lokalisierungsstroms) nachverfolgt werden kann.

Der Lokalisierungsstrom wird dabei von allen Prüfstromsensoren, die in dem Stromkreis des Lokalisierungsstroms (Prüfstromkreis) liegen, erfasst und in der Auswerteeinheit des Isolationsfehlerlokalisierungssystems ausgewertet und angezeigt. Durch die bekannte Zuordnung der Prüfstromsensoren zu den Leitungsabschnitten kann der Fehlerort lokalisiert werden.

Insbesondere in bereits bestehenden elektrischen Anlagen besteht ein erhöhter Bedarf an dem Ausbau oder der Nachrüstbarkeit derartiger Isolationsfehlerlokalisierungssysteme. Entscheidend für die Akzeptanz einer Isolationsfehlersucheinrichtung in existierenden Anlagen ist die Möglichkeit einer hinsichtlich der Kosten und des Aufwands günstigen Nachrüstung. Um diese grundlegenden Anforderungen zu erfüllen, wird eine Prüfstromsensorik zur Erfassung des Lokalisierungsstromes mit folgenden Eigenschaften benötigt:
- Kleine, kompakte Baugröße und Eignung zum nachträglichen Einbau bei enger, ungünstig erreichbarer elektrischer Kabelführung in bestehenden Anlagen ohne Umbau der Verkabelung,
- sehr geringe Leistungsaufnahme, um die Nachrüstung an Orten ohne verfügbaren Netzanschluss (Steckdose) zu ermöglichen,
- sehr hohe Magnetfeld-Messempfindlichkeit - im Bereich von einigen mA - zur Erfassung des eingespeisten Prüfstroms zur Fehlerlokalisierung, wobei die Frequenz des Lokalisierungsstroms, bedingt durch die übliche Größe von Netzableitkapazitäten, meistens im Bereich deutlich unterhalb von 10 Hz liegt,
- ungestörte Fehlerlokalisierung bei netzfrequenten Lastströmen bis zum Bereich einiger 100 A,
- keine Zerstörungs- oder nennenswerte Sättigungseffekte bei Kurzschlussströmen im kA-Bereich,
- die Sensorkosten müssen zusammen mit den Kosten für das übrige Fehlerlokalisierungssystem einen deutlichen wirtschaftlichen Vorteil gegenüber herkömmlichen Fehlerlokalisierungsmethoden bieten.

Bislang erfüllt kein nach dem Stand der Technik verfügbares Strommessprinzip alle vorgenannten Eigenschaften. Bekannte Messmethoden zur Erfassung des Lokalisierungsstroms weisen daher folgende Nachteile auf:
- Eine Potential-gebundene Messung mit Shunt-Widerständen wird in den meisten Anwendungsfällen als Nachrüstlösung nicht akzeptiert, da die elektrische Anlage hierfür vollständig umgebaut werden müsste. Zudem ist die entstehende hohe Verlustleistung bei hohen Lastströmen eine weitere unerwünschte Eigenschaft.
- Stromwandler nach dem Rogowski-Prinzip sind gut nachrüstbar, können aber nicht die benötigte sehr hohe Magnetfeld-Messempfindlichkeit im mA-Bereich bei Frequenzen unterhalb von 10 Hz erbringen.
- Stromtransformatoren mit einem hochpermeablen weichmagnetischen Kern und einer Bauform mit geringem Luftspalt können so ausgelegt werden, dass eine hohe Magnetfeld-Messempfindlichkeit im mA-Bereich bei Frequenzen unterhalb 10 Hz erreicht wird. Eine störungsfreie Fehlerlokalisierung bei netzfrequenten Lastströmen bis zum Bereich einiger 100 A wird jedoch nur umsetzbar sein, wenn Stromsensoren in Form von Differenzstromwandlern zum Einsatz kommen. Hierfür sind aber bestimmte Voraussetzungen bei der Kabelverlegung einzuhalten, die deutlich mehr Bauraum im Schaltschrank benötigen und daher in der Praxis selten optimal anzutreffen sind. Gerade bei größeren Lastströmen werden Differenzstromwandler mit größerem Kernvolumen benötigt. Dies erschwert erheblich die Nachrüstung in bestehenden Anlagen und führt bei einigen Anwendungen zum Überschreiten wirtschaftlich vernünftiger Grenzen. Bei größeren Kurzschlussströmen im kA-Bereich ist zudem mit Sättigungseffekten und ohne zusätzliche Maßnahmen auch mit Zerstörung zu rechnen.
- Nullflusswandler nach dem Kompensationsprinzip mit Fluxgate-Induktionssensor erfüllen optimal die messtechnischen Anforderungen. Um allerdings die Funktion bei hohen Lastströmen aufrecht zu erhalten und die negativen Einflüsse von großen Kurzschlussströmen zu minimieren, ist ein erheblich größerer Aufwand erforderlich als bei Stromtransformatoren oder Differenzstromwandlern. Neben den deutlich höheren Kosten erfordert das Kompensationsprinzip in Verbindung mit einem großen, hochpermeablen Kern auch deutlich mehr Versorgungsleistung für den Sensor. Die Nachrüstung ist somit in vielen Anwendungen noch kritischer als bei Stromtransformatoren oder Differenzstromwandlern.
- Stromwandler nach dem Kompensationsprinzip mit Einsatz anderer Magnetfeldsensoren wie z. B. Hallsensoren oder GMR-Sensoren (Giant Magneto-Resistive) erfüllen selten die messtechnischen Anforderungen an den extrem hohen Dynamikbereich. Für den benötigten hohen Dynamikbereich liegen die Kosten dieser Lösungen außerhalb des akzeptablen Bereichs, um bei den hier betrachteten Anwendungen zum Einsatz zu gelangen.

So ist aus der Offenlegungsschrift DE 10 2015 214 615 A1 ein Verfahren und eine Vorrichtung zur Isolationsfehlersuche in einem verzweigten IT-Stromversorgungssystem bekannt, wobei ein multifunktionaler Prüfstrom applikationsabhängig eingespeist wird. Die in dem jeweiligen Subsystem fließenden Prüfstromanteile werden von Fehlerstrom-Schutzeinrichtungen mit (Prüf-)Stromsensoren erfasst.

Die Patentschrift US 5 075 628 A zeigt ein System zur Isolationsüberwachung in einem DC-Stromversorgungssystem mit einem Hall-Effekt-Stromsensor, der eine Kompensationswicklung eines weiteren Stromsensors ansteuert.

Wenn somit aus den vorgenannten Gründen der Aufwand für einen nachträglichen Einbau eines Fehlerlokalisierungssystems keinen wirtschaftlichen Vorteil gegenüber einer manuellen Fehlersuche durch eine Elektrofachkraft bietet, so wurde bislang auch kein Fehlerlokalisierungssystem verwendet und an der manuellen Fehlersuche festgehalten. Als Hauptnachteil erweist sich hierbei, dass ein in der elektrischen Anlage aufgetretener erster Isolationsfehler bei einer manuellen Fehlersuche sehr viel länger ansteht, da die Fehlerlokalisierung deutlich mehr Zeit in Anspruch nimmt als eine durch ein Fehlerlokalisierungssystem unterstützte Fehlersuche.

Zudem entstehen durch die manuelle Fehlersuche häufig zusätzliche

Risiken für die Elektrofachkraft. Beispielsweise ist bei der manuellen Fehlersuche in Photovoltaiksystemen ohne installiertes Isolationsfehlerlokalisierungssystem im ungünstigsten Fall ein Arbeiten unter Spannung erforderlich.

Der vorliegenden Erfindung liegt somit die Aufgabe zu Grunde, für ein Isolationsfehlerlokalisierungssystem in einem Wechselstrom-Stromversorgungssystem eine Prüfstromsensorik zur Erfassung eines Lokalisierungsstroms zu schaffen, die kostengünstig und einfach nachrüstbar ist.

Die Aufgabe wird durch eine Magnetfeld-Messvorrichtung mit den Merkmalen des Anspruchs 1 gelöst.

Die Magnetfeld-Messvorrichtung umfasst eine an dem zu prüfenden Leitungsabschnitt - welcher nicht Bestandteil der Erfindung ist - anzubringende Stromsensoranordnung, welche aus einem ersten Stromsensor, einem zweiten Stromsensor und einer Kompensationsspule besteht. Die Kompensationsspule erzeugt ein Kompensations-Magnetfeld, welches sich in einem Erfassungsbereich des ersten Stromsensors ausbildet und nur dort eine Teil-Kompensation eines von dem Laststrom hervorgerufenen netzfrequenten Wechselmagnetfeldes bewirkt.

Weiterhin umfasst die Magnetfeld-Messvorrichtung einen ersten Signalaufbereitungsblock, einen zweiten Signalaufbereitungsblock und einen Kompensationsblock.

Der erste Stromsensor und der zweite Stromsensor sind so anzuordnen, dass der erste Stromsensor neben dem von der Kompensationsspule erzeugten Kompensations-Magnetfeld auch das Wechselmagnetfeld des Laststroms sowie ein von dem Lokalisierungsstrom bewirktes Gleichtakt-Magnetfeld erfasst. Dieses im Erfassungsbereich des ersten Stromsensors sich ausbildende Magnetfeld wird hier als teil-kompensiertes Magnetfeld bezeichnet. Die Stromsensoranordnung, insbesondere die Beabstandung des ersten Stromsensors von dem zweiten Stromsensor, ist dabei so ausgeführt, dass der Einfluss des von der Kompensationsspule erzeugten Kompensations-Magnetfeldes auf den zweiten Stromsensor vernachlässigbar ist, sodass der zweite Stromsensor nur das Wechselmagnetfeld und das von dem Lokalisierungsstrom bewirkte Gleichtakt-Magnetfeld als resultierendes Magnetfeld erfasst.

Somit bewirkt das von der Kompensationsspule erzeugte Kompensations-Magnetfeld in dem Erfassungsbereich des ersten Stromsensors eine Teil-Kompensation des netzfrequenten Wechselmagnetfeldes, stört aber nicht die Erfassung des Wechselmagnetfeldes und des Gleichtakt-Magnetfeldes im Erfassungsbereich des zweiten Stromsensors.

Der erste Signalaufbereitungsblock erzeugt aus einem von dem ersten Stromsensor erzeugten ersten Sensor-Ausgangssignal ein den Lokalisierungsstrom anzeigendes Lokalisierungssignal. Dieses Lokalisierungssignal spiegelt somit das Vorhandensein des Lokalisierungsstroms in dem zu prüfenden Leitungsabschnitt wider und kann in Verbindung mit einem Isolationsfehlerlokalisierungssystem als Detektionssignal an eine Auswerteeinheit des Isolationsfehlerlokalisierungssystems weitergeleitet werden.

Der zweite Signalaufbereitungsblock, welcher ein von dem zweiten Stromsensor aus dem erfassten resultierenden Magnetfeld abgeleitetes zweites Sensorsignal empfängt, erzeugt daraus ein entsprechendes Wechselspannungssignal.

Der dem zweiten Signalaufbereitungsblock nachgeschaltete Kompensationsblock erzeugt aus dem Wechselspannungssignal einen Kompensationsstrom, welcher die Kompensationsspule zur Erzeugung des Kompensations-Magnetfeldes speist.

Weiterhin weist der zweite Signalaufbereitungsblock einen Signaleingang zum Empfang eines Synchronisationssignals auf, um eine von dem übergeordneten Isolationsfehlerlokalisierungssystem vorgegebene Messperiode, während der eine Detektion des Lokalisierungsstroms ausgeführt wird, mit dem Wechselspannungssignal zu synchronisieren. Diese Synchronisationsmaßnahme stellt sicher, dass während der Messperiode, in der in einer Auswerteeinheit des Isolationsfehlerlokalisierungssystems die Detektion des Lokalisierungsstroms abläuft, das von dem zweiten Signalaufbereitungsblock gelieferte Wechselspannungssignal unverändert bleibt - gleichbedeutend mit einem während der Messperiode konstanten Effektivwert dieses Wechselspannungssignals.

In erfindungsgemäßer und vorteilhafter Weise sind die Stromsensoren so ausgelegt, dass der zweite Stromsensor gegenüber dem ersten Stromsensor eine deutlich geringere Magnetfeld-Messempfindlichkeit und einen deutlich größeren Magnetfeld-Messbereich aufweist - eine geringere Magnetfeld-Messempfindlichkeit ist gleichbedeutend mit einer geringeren Messwert-Auflösung und spiegelt sich in einem größeren Zahlenwert der Messempfindlichkeit wider. Die Kompensation des von dem Laststrom bewirkten netzfrequenten Wechselmagnetfeldes erfolgt also in dem Erfassungsbereich des ersten Stromsensors nur soweit, dass das dort vorhandene teil-kompensierte Magnetfeld den Magnetfeld-Messbereich des ersten Stromsensors nicht überschreitet.

Es ist somit ausreichend, wenn die Kompensation soweit gelingt, dass sich das in dem Erfassungsbereich des ersten Stromsensors verbleibende teil-kompensierte Magnetfeld in dem Messbereich des empfindlicheren ersten Stromsensors befindet.

Gegenüber dem ersten Stromsensor ist der zweite Stromsensor unempfindlicher, ist aber dafür in der Lage, größere Wechselmagnetfelder zu verarbeiten.

Es erfolgt keine vollständige Kompensation des netzfrequenten Wechselmagnetfeldes, sondern es ist ausreichend, dass das verbleibende teil-kompensierte Magnetfeld den Magnetfeld-Messbereich des empfindlicheren ersten Stromsensors nicht übersteuert.

Hinsichtlich der Magnetfeld-Messempfindlichkeiten muss die Kombination der beiden Stromsensoren das Magnetfeld des Lokalisierungsstroms hinreichend erfassen und hinsichtlich des Magnetfeld-Messbereiches das Magnetfeld des Laststroms abdecken.

Aus dieser erfindungsgemäßen Kombination zweier Stromsensoren mit unterschiedlichen Magnetfeld-Messempfindlichkeiten und unterschiedlichen Magnetfeld-Messbereichen folgt, dass die dem unempfindlicheren zweiten Stromsensor nachgeschaltete digitale Signalverarbeitung wesentlich weniger aufwändig und damit kostengünstig ausgeführt werden kann.

In weiterer vorteilhafter Ausgestaltung ist der zweite Signalaufbereitungsblock so ausgelegt, dass das erzeugte Wechselspannungssignal während der Messperiode unverändert fortgesetzt wird, wobei sich die Messperiode über mehrere Perioden des Lokalisierungsstroms erstreckt.

Um störende Einflüsse auf die Fehlerlokalisierung zu vermeiden, d. h. um eine störungsfreie Detektion des Lokalisierungsstroms innerhalb der Messperiode zu gewährleisten, wird das von dem zweiten Signalaufbereitungsblock erzeugte Wechselspannungssignal während der Messperiode nicht verändert. Wie oben bemerkt bleibt der Effektivwert des Wechselspannungssignals während der sich über mehrere Perioden des Lokalisierungsstroms erstreckenden Zeitdauer (Messperiode) konstant und es erfolgt kein Regelungs- oder Stellvorgang bezogen auf das Wechselspannungssignal, um beispielsweise dadurch einen sich ändernden Laststrom zu berücksichtigen.

Die Messperiode ist bevorzugt so lange gewählt, dass ganzzahlige Perioden des Lokalisierungsstroms abgedeckt sind. Erst danach führen Änderungen des netzfrequenten Wechselmagnetfeldes auch zu einer Anpassung des Wechselspannungssignals und damit auch des das Kompensations-Magnetfeld erzeugenden Kompensationsstroms.

Mit Vorteil weist der zweite Signalaufbereitungsblock eine Übersteuerungserkennung zum Erzeugen eines Übersteuerungssignals bei einer Übersteuerung des Magnetfeld-Messbereiches des ersten Stromsensors auf.

Sollte sich während einer Messperiode das netzfrequente Wechselfeld so stark ändern, dass der erste Stromsensor trotz Kompensation übersteuert wird, so kann das von dem ersten Stromsensor gelieferte erste Sensor-Ausgangssignal nicht mehr zur Weiterverarbeitung genutzt werden. Eine Weiterführung der Messperiode mit dem fehlerhaften ersten Sensor-Ausgangssignal würde zu einem unzuverlässigen Detektionsergebnis für den Lokalisierungsstrom führen.

Der zweite Signalaufbereitungsblock wird daher mit einer Übersteuerungserkennung erweitert, die eine Übersteuerung des ersten Stromsensors feststellt und ein Übersteuerungssignal an das Isolationsfehlerlokalisierungssystem sendet, um die Messperiode neu zu starten.

Weiterhin weist der Kompensationsblock eine Anpassungsschaltung zum Anpassen des Kompensationsstroms und einen Signaleingang zum Empfangen eines von dem zweiten Signalaufbereitungsblock erzeugten Anpassungssignals auf.

In dem Kompensationsblock findet bei Empfang des von dem zweiten Signalaufbereitungsblock erzeugten Anpassungssignals zugleich mit dem Start der neuen Messperiode eine Anpassung des Kompensationsstroms derart statt, dass das von dem ersten Stromsensor erfasste teil-kompensierte Magnetfeld den Magnetfeld-Messbereich des ersten Stromsensors nicht (mehr) überschreitet.

Bevorzugt ist der erste Signalaufbereitungsblock zur Erzeugung eines Fein-Kompensationssignals ausgelegt, welches dem Kompensationsblock zur Fein-Kompensation des Wechselmagnetfeldes zugeführt wird.

Der erste Signalaufbereitungsblock erzeugt aus dem ersten Sensor-Ausgangssignal des ersten Stromsensors ein Fein-Kompensationssignal, welches phasensynchron zum erfassten, netzfrequenten Wechselmagnetfeld ist und dessen Amplitude der nicht vollständig kompensierten Wirkung dieses Wechselmagnetfeldes auf den ersten Stromsensor entspricht. Diese Fein-Kompensation kann zum Einsatz kommen, um die Messunsicherheit der gesamten Stromsensoranordnung dadurch zu reduzieren, dass der Arbeitsbereich des ersten Stromsensors bezüglich des Lokalisierungsstroms konstant gehalten wird. Das von dem ersten Signalaufbereitungsblock erzeugte Fein-Kompensationssignal wird während einer Messperiode des Lokalisierungsstroms konstant gehalten.

In einer konkreten Ausführungsform ist die Kompensationsspule vorteilhaft als Planarspule ausgeführt, deren Wicklung als Leiterbahn auf einer Leiterplatte ausgeführt ist und die einen Planarkern aus Ferrit aufweist.

Eine einfache und kostengünstige Realisierung der Kompensationsspule besteht darin, dass deren Wicklung als Leiterbahn auf eine Leiterplatte aufgebracht wird.

Bevorzugt weist der Planarkern konzentrisch einen Luftspalt auf, in den der erste Stromsensor angeordnet ist.

Eine besonders effektive Kompensation des Wechselmagnetfeldes bei gleichzeitig kompakter Bauweise kann dadurch erzielt werden, indem der erste Stromsensor in einem konzentrischen Luftspalt des Planarkerns angeordnet ist.

Mit Vorteil ist die Magnetfeld-Messvorrichtung als eigenständige Baugruppe bestehend aus der Leiterplatte und einem Gehäuse oder einer Vergussmasse ausgeführt, wobei auf der Leiterplatte zusätzlich elektronische Bauelemente zur Signalverarbeitung angeordnet sind.

Eine Ausführung der Magnetfeld-Messvorrichtung als kompakte eigenständige Baugruppe eröffnet in kostengünstiger Weise die Möglichkeit einer einfachen Nachrüstung. Insbesondere bei beengten räumlichen Verhältnissen, wo wenig Bauraum zur Verfügung steht, beispielsweise in einem Schaltschrank, besitzt diese Lösung im Vergleich zu der Verwendung von Messstromwandlern Vorteile.

Vorteilhafterweise ist der zweite Stromsensor auf der Leiterplatte angeordnet oder als separate bauliche Einheit ausgeführt.

In besonders kompakter Bauweise befindet sich der zweite Stromsensor ebenfalls auf der Leiterplatte. Er kann aber auch als separate bauliche Einheit ausgeführt sein, entscheidend ist, dass die konstruktive Anordnung der Sensoren in der Baugruppe so ausgeführt ist, dass die Wirkung des netzfrequenten Wechselmagnetfeldes und des Gleichtakt-Magnetfeldes auf den ersten Stromsensor und den zweiten Stromsensor jeweils gleich ist. Eine in den jeweiligen Erfassungsbereichen der Stromsensoren unterschiedlich wirkende Magnetfeldstärke würde zu einem größeren nicht kompensierten netzfrequenten Wechselmagnetfeld im Erfassungsbereich des ersten Stromsensors führen, dies darf nicht zu einer Übersteuerung des ersten Stromsensors führen.

Bevorzugt wird die erfindungsgemäße Magnetfeld-Messvorrichtung als Vorrichtung zur Lokalisierungsstrom-Erfassung (Prüfstromerfassung, Prüfstromsensorik) für ein Isolationsfehlerlokalisierungssystem in einem Wechselstrom-Stromversorgungssystem verwendet, wobei das Lokalisierungssignal an eine Auswerteeinheit des Isolationsfehlerlokalisierungssystems weitergeleitet wird, das Synchronisationssignal von dem Isolationsfehlerlokalisierungssystem mitgeteilt wird und das Übersteuerungssignal dem Isolationsfehlerlokalisierungssystem zugeführt wird.

Das Lokalisierungssignal, welches dem übergeordneten Isolationsfehlerlokalisierungssystem das Vorhandensein des Lokalisierungsstroms signalisiert, sowie das Übersteuerungssignal als Auslöser für einen Neustart der Messperiode werden dem Isolationsfehlerlokalisierungssystem zugeführt. Im Gegenzug empfängt der zweite Signalaufbereitungsblock das Synchronisationssignal von dem Isolationsfehlerlokalisie rungssystem, um das Wechselspannungssignal mit der Messperiode zu synchronisieren.

Als Bestandteil und insbesondere als Ersatz für die nach dem Stand der Technik verwendeten Messstromwandler stellt die erfindungsgemäße Magnetfeld-Messvorrichtung eine kostengünstige und einfach in das Isolationsfehlerlokalisierungssystem zu integrierende Lösung zur Erfassung des Lokalisierungsstroms dar.

Die zuverlässige Detektion von niederfrequenten, kleinen Lokalisierungsströmen bei vorhandenen großen netzfrequenten Lastströmen wird erfindungsgemäß durch zwei Stromsensoren unterschiedlicher Empfindlichkeit realisiert, wobei diese Magnetfeld-Messvorrichtung aufgrund ihrer kompakten Konstruktion auf den Einsatz in Isolationsfehlerlokalisierungssystemen hin ausgerichtet ist.

In vorteilhafter Weise kommt hierbei gegenüber den aus dem Stand der Technik bekannten Lösungen kein weichmagnetischer Magnetkern eines Differenzstrom-/Messstromwandlers zum Einsatz, der die stromführenden Leiter des zu überwachenden Leitungsabschnitts umschließen müsste. Stattdessen erfüllt die erfindungsgemäße Ausgestaltung die Anforderungen an eine einfache und kostengünstige Nachrüstbarkeit in bestehenden Anlagen. Das Ziel der Verwendung der erfindungsgemäßen Magnetfeld-Messvorrichtung als Vorrichtung zur Prüfstromerfassung für ein Isolationsfehlerlokalisierungssystem besteht darin, möglichst empfindlich Lokalisierungsströme zu detektieren, um Isolationsfehler in einem Wechselstrom-Stromversorgungssystem möglichst schnell zu finden und in einem nachfolgenden Schritt beseitigen zu können. Eine möglichst exakte Bestimmung von Last- oder Differenzströmen steht damit nicht im Vordergrund der vorliegenden Erfindung.

Die der Erfindung zugrundeliegende Aufgabe wird weiterhin durch ein Verfahren mit den Merkmalen nach Anspruch 11 gelöst.

Die erfindungsgemäße Magnetfeld-Messvorrichtung beruht auf einem Verfahren zur Erfassung eines Lokalisierungsstroms in einem verzweigten Wechselstrom-Stromversorgungssystem. Insoweit treffen auch die vorgenannten technischen Wirkungen und daraus resultierenden Vorteile auf die Verfahrensmerkmale zu.

Insbesondere kann durch die Kombination von zwei Stromsensoren mit unterschiedlicher Magnetfeld-Messempfindlichkeit und mit unterschiedlichem Magnetfeld-Messbereich erreicht werden, dass eine zuverlässige Detektion von Lokalisierungsströmen in Isolationsfehlerlokalisierungssystemen in konstruktiv einfacher und kostengünstiger Realisierung, insbesondere als Nachrüstung in bestehenden Anlagen, möglich wird.

Weitere vorteilhafte Ausgestaltungsmerkmale ergeben sich aus den nachfolgenden Beschreibungen und den Zeichnungen, die eine bevorzugte Ausführungsform der Erfindung anhand von Beispielen erläutern.

Es zeigen
- Fig. 1: eine erfindungsgemäße Magnetfeld-Messvorrichtung in schematischer Darstellung,
- Fig. 2: eine Sensoranordnung der Magnetfeld-Messvorrichtung,
- Fig. 3: einen Laststrom- und einen Lokalisierungsstrom in normierter Darstellung,
- Fig. 4: eine Überlagerung des Laststroms und des Lokalisierungsstroms in normierter Darstellung,
- Fig. 5: einen Kompensationsstrom in normierter Darstellung,
- Fig. 6: Sensor-Ausgangssignale des ersten Stromsensors in normierter Darstellung,
- Fig. 7: Zeitdiagramm zum Synchronisationsverhalten,
- Fig. 8: Zeitdiagramm zum Synchronisationsverhalten bei Übersteuerung des ersten Stromsensors und
- Fig. 9: eine Realisierung der Magnetfeld-Messvorrichtung in schematischer Darstellung.

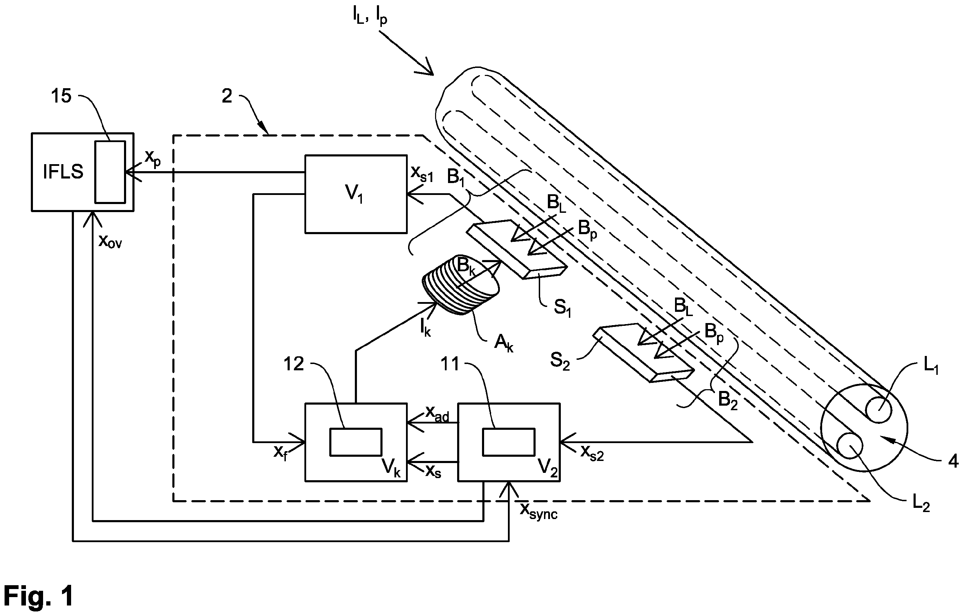

In **Fig. 1** ist eine erfindungsgemäße Magnetfeld-Messvorrichtung 2 und deren Lage in Bezug auf einen zu überwachenden Leitungsabschnitt 4 in schematischer Darstellung gezeigt.

Der Leitungsabschnitt 4 umfasst zwei aktive Leiter L1, L2, in denen ein Laststrom IL zur Speisung angeschlossener Verbraucher und ein (Gleichtakt-)Lokalisierungsstrom Ip zur Verfolgung eines Prüfstrom-(Lokalisierungsstrom-)Kreises fließen.

Der Laststrom IL erzeugt ein Wechselmagnetfeld BL, der in den beiden aktiven Leitern L1 und L2 im Gleichtakt fließende Lokalisierungsstrom IP erzeugt ein Gleichtakt-Magnetfeld Bp. Entlang des zu überwachenden Leitungsabschnitts 4 sind ein erster Stromsensor S1 und ein zweiter Stromsensor S2 derart angeordnet, dass beide Stromsensoren S1, S2 der gleichen, aus dem Wechselmagnetfeld BL und dem Gleichtakt-Magnetfeld Bp bestehenden Magnetfeldstärke ausgesetzt sind. Die beiden Stromsensoren S1, S2 sind aber so weit voneinander beabstandet, dass ein durch einen Kompensationsstrom Ik, welcher in einer Kompensationsspule Ak fließt, bewirktes Kompensations-Magnetfeld Bk nur auf den ersten Stromsensor S1 einwirkt.

Der zweite Stromsensor S2 erfasst somit ein resultierendes Magnetfeld B2, welches sich aus dem Wechselmagnetfeld BL und dem Gleichtakt-Magnetfeld Bp zusammensetzt, und liefert ein zweites Sensor-Ausgangssignal xs2 an einen zweiten Signalaufbereitungsblock V2. Der zweite Signalaufbereitungsblock V2 generiert daraus ein Wechselspannungssignal xs, welches einem Kompensationsblock Vk zugeführt wird, der daraus den Kompensationsstrom Ik erzeugt, welcher die Kompensationsspule Ak zum Aufbau des Kompensations-Magnetfeldes Bk speist.

Der erste Stromsensor S1 erfasst als teil-kompensiertes Magnetfeld B1 neben dem Wechselmagnetfeld BL und dem Gleichtakt-Magnetfeld Bp zusätzlich das von der Kompensationsspule Ak erzeugte KompensationsMagnetfeld Bk.

Ein dem teil-kompensierten Magnetfeld B1 entsprechendes erstes Sensor-Ausgangssignal xs1 des ersten Stromsensors S1 wird einem ersten Signalaufbereitungsblock V1 zugeführt, der daraus mittels Methoden der digitalen Signalverarbeitung ein Lokalisierungssignal xp erzeugt, das ein Auftreten des Lokalisierungsstroms Ip in dem zu überwachenden Leitungsabschnitt 4 anzeigt und an eine übergeordnete Auswerteeinheit 15 eines Isolationsfehlerlokalisierungssystems IFLS weitergeleitet wird.

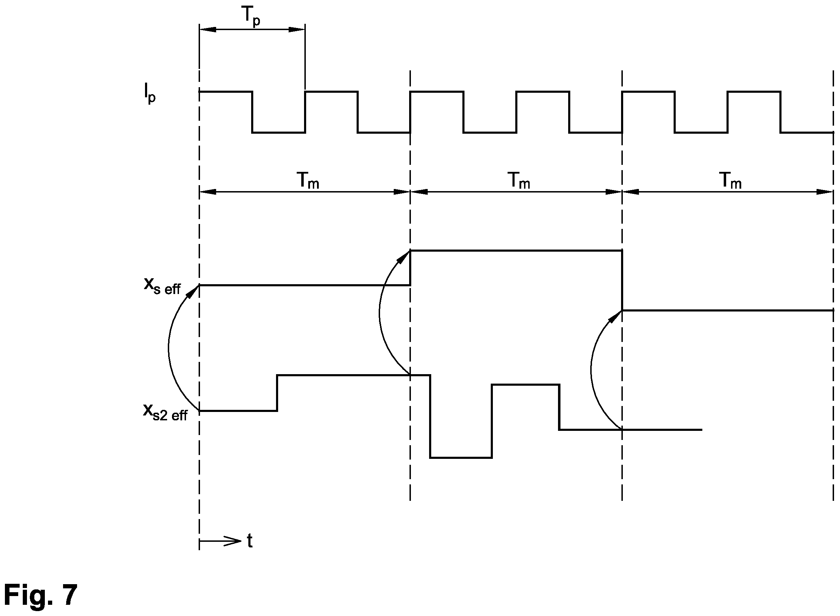

Ausgehend von der Auswerteeinheit 15 des Isolationsfehlerlokalisierungssystems IFLS führt ein Synchronisationssignal xsync zu dem zweiten Signalaufbereitungsblock V2, um den zeitlichen Verlauf des Wechselspannungssignals xs mit einer von dem übergeordneten Isolationsfehlerlokalisierungssystem IFLS vorgegebenen Messperiode Tm (Fig. 7), während der eine Detektion des Lokalisierungsstroms Ip ausgeführt wird, zu synchronisieren.

Der zweite Signalaufbereitungsblock V2 umfasst eine Übersteuerungserkennung 11 zum Erzeugen eines Übersteuerungssignals xov bei einer Übersteuerung des Magnetfeld-Messbereiches des ersten Stromsensors S1. Das Übersteuerungssignals xov wird an das Isolationsfehlerlokalisierungssystem IFLS übermittelt, das einen Neustart der Messperiode Tm veranlasst und diesen Neustart über das Synchronisationssignal xsync dem zweiten Signalaufbereitungsblock V2 mitteilt.

Der Kompensationsblock Vk empfängt ein Anpassungssignal xad von dem zweiten Signalaufbereitungsblock V2, um in einer Anpassungsschaltung 12 den Kompensationsstrom Ik an den Magnetfeld-Messbereich des ersten Stromsensors S1 anzupassen.

Optional erzeugt der erste Signalaufbereitungsblock V1 aus dem von dem ersten Stromsensor S1 gelieferten Ausgangssignal ein Fein-Kompensationssignal xf als weiteres Wechselspannungssignal, welches phasensynchron zum erfassten, netzfrequenten Wechselmagnetfeld BL ist und dessen Amplitude der nicht vollständig kompensierten Wirkung dieses Wechselmagnetfeldes BL auf den Stromsensor S1 entspricht. Das Fein-Kompensationssignal xf wird dem Kompensationsblock Vk zugeführt und kann zum Einsatz kommen, um die Messunsicherheit der Magnetfeld-Messvorrichtung 2 dadurch zu reduzieren, dass der Magnetfeld-Messbereich des Stromsensors S1 nicht überschritten wird.

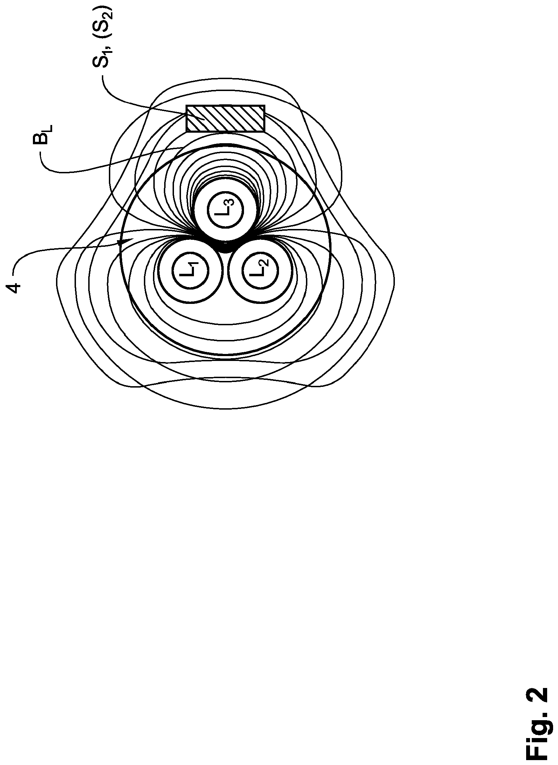

Die **Fig. 2** zeigt eine Stromsensoranordnung der Stromsensoren S1, S2 mit dem zu überwachenden Leitungsabschnitt 4 in einer Querschnittsdarstellung. Der zu überwachende Leitungsabschnitt 4 umfasst drei aktive Leiter L1, L2, L3, die den Laststrom IL (Fig. 1) führen, welcher im Erfassungsbereich der Stromsensoren S1, S2 ein Wechselmagnetfeld BL erzeugt.

Die beiden Stromsensoren S1, S2 sind entlang der Längserstreckung des Leitungsabschnitts 4 hintereinander und in Umfangsrichtung des Leitungsabschnitts 4 beide in Höhe des Leiters L3 angeordnet - in dieser Querschnittsdarstellung wird der zweite Stromsensor S2 durch den ersten Stromsensor S1 verdeckt und ist nicht sichtbar. Simulationen des von dem Laststrom erzeugten Wechselmagnetfeldes BL und des von dem Lokalisierungsstrom bewirkten Gleichtakt-Magnetfeldes Bp haben ergeben, dass es sich als günstig erweist, die beiden Stromsensoren S1, S2 umfänglich in Höhe eines aktiven Leiters L1, L2, L3 anzuordnen, um eine möglichst gute Erfassung des Wechselmagnetfeldes BL zu erreichen.

Zur effektiven Erfassung des durch den Lokalisierungsstrom Ip bewirkten Gleichtakt-Magnetfeldes Bp ist es weiter zweckmäßig, die Stromsensoren S1, S2 von dem Leitungsabschnitt 4 ausgehend in Richtung Erde anzuordnen.

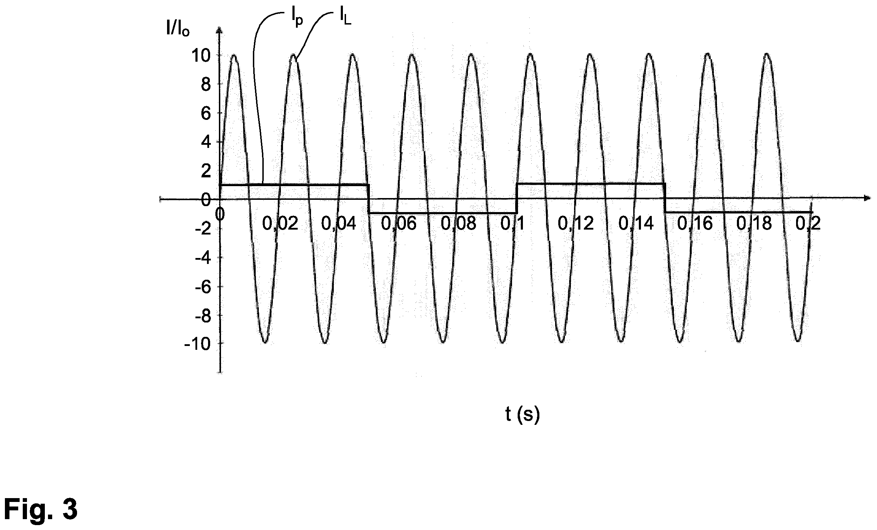

Die folgenden **Figuren 3 bis 6** zeigen jeweils Strom- und Signalverläufe an verschiedenen Messpunkten der Magnetfeld-Messvorrichtung 2. Um das Wirkprinzip der erfindungsgemäßen Magnetfeld-Messvorrichtung 2 zu verdeutlichen, ist das Größenverhältnis des Lokalisierungsstroms Ip zu dem netzfrequenten Laststrom IL auf 1 zu 10 statt eines real zu erwartenden Verhältnisses von 1 zu 1000 reduziert worden. Zudem erfolgen die Größenangaben in normierter Darstellung.

**Fig. 3** zeigt den netzfrequenten, sinusförmigen Laststrom IL im Verhältnis zu dem Lokalisierungsstrom Ip, der hier einen rechteckförmigen Verlauf aufweist. Die Frequenz des Laststroms IL beträgt 50 Hz (Netzfrequenz), die Grundfrequenz der Rechteckschwingung des Lokalisierungsstroms Ip beträgt 10 Hz, was einer Periodendauer Tp (Fig. 7) von 0,1 s entspricht. Grundsätzlich sind neben dem rechteckförmigen Verlauf des Lokalisierungsstroms Ip auch andere Kurvenformen wie beispielsweise Sinus- oder Dreieck-Schwingungen mit gegebenenfalls anderen Frequenzen verwendbar, solange sich daraus nach Erfassung und Signalaufbereitung ein auswertbares Lokalisierungssignal xp ergibt.

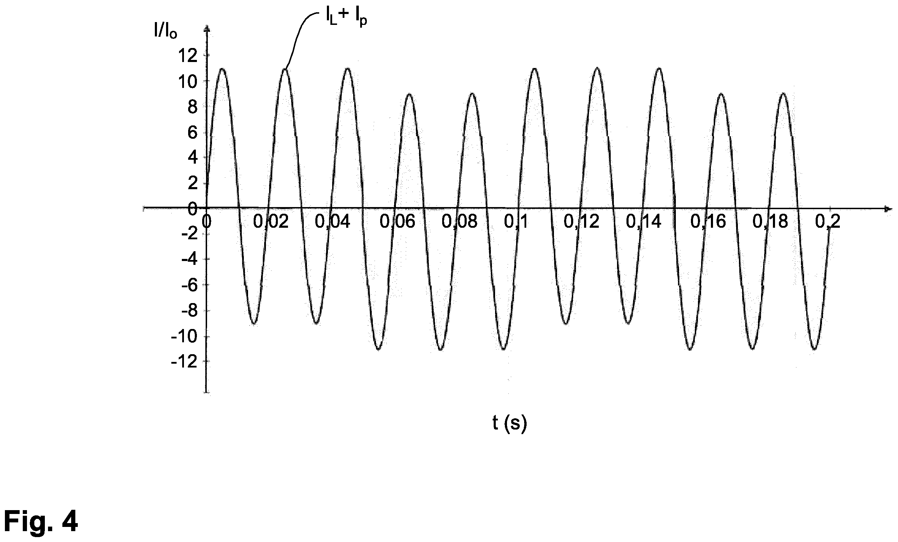

In **Fig. 4** ist die Überlagerung des in Fig. 3 dargestellten Laststroms IL mit dem in Fig. 3 dargestellten Lokalisierungsstrom Ip gezeigt. Dieser Stromverlauf erzeugt ein in gleicher Weise auf den ersten Stromsensor S1 und auf den zweiten Stromsensor S2 einwirkendes Magnetfeld, bestehend aus dem Wechselmagnetfeld BL und dem Gleichtakt-Magnetfeld Bp.

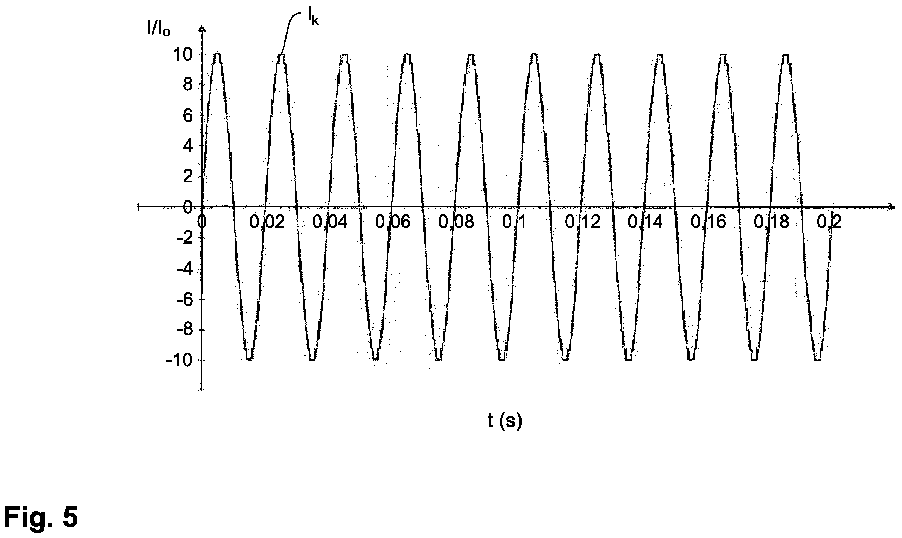

In **Fig. 5** ist der Verlauf des Kompensationsstroms Ik dargestellt, welcher die Kompensationsspule Ak zur Erzeugung des Kompensations-Magnetfeldes Bk speist. Zu erkennen ist die infolge der geringen Magnetfeld-Messempfindlichkeit des Stromsensors S2 grobe Quantisierung des Kompensationsstroms Ik. Zur besseren Illustration wurde die Quantisierung hier mit 5 Bit, entsprechend 32 Quantisierungsstufen, durchgeführt.

In der Praxis sollte die Magnetfeld-Messempfindlichkeit des ersten Stromsensors S1 so hoch sein, dass das Magnetfeld des Lokalisierungsstroms Ip so hoch aufgelöst werden kann, dass eine zuverlässige Detektion des Lokalisierungsstroms Ip möglich ist. Hinsichtlich des Magnetfeld-Messbereiches sollte ein im Rahmen von wirtschaftlichen Erwägungen möglichst großer Dynamikumfang angestrebt werden. Kostenmäßig vertretbar erscheint eine Abbildung des Dynamikumfangs mit 14 bis 16 Bit.

Der Magnetfeld-Messbereich des zweiten Stromsensors S2 sollte so groß sein, dass die maximale Stärke des durch den netzfrequenten Laststrom IL bewirkten Wechselmagnetfeldes BL ohne Messbereichsüberschreitung verarbeitet werden kann. Der Dynamikumfang des zweiten Stromsensors S2 sollte so bemessen sein, dass die Magnetfeld-Messempfindlichkeit des zweiten Stromsensors S2 in etwa 64 (entspricht 6 Bit) bis 512 (entspricht 9 Bit) mal geringer sein kann, als die des ersten Stromsensors S1. Üblicherweise reicht ein Dynamikumfang für den zweiten Stromsensor S2 aus, der sich mit 12 Bit abbilden lässt. Der Gesamt-Dynamikumfang der durch die Kombination des ersten und des zweiten Stromsensors S1, S2 erfassten Messwerte erreicht in etwa 22 Bit bis 24 Bit.

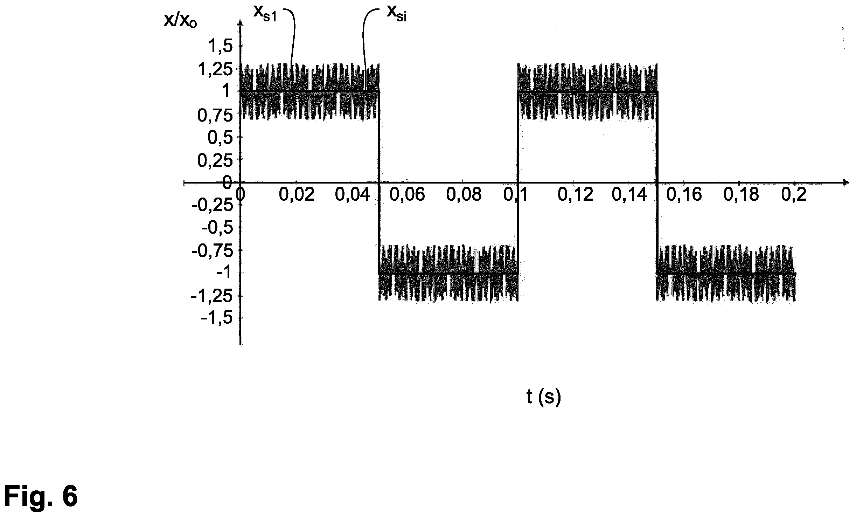

**Fig. 6** zeigt ein Sensor-Ausgangssignal xs1 des ersten Stromsensors S1 nach der Kompensation im Vergleich zu einem Sensor-Ausgangssignal xsi, welches aufgrund eines eingeprägten, ungestörten Lokalisierungsstroms Ip verursacht wird.

Der mittlere Pegel eines positiven/negativen (Prüf-)Impulses des Sensor-Ausgangssignal xs1 nach der Kompensation entspricht dabei einem ungestörten Sensor-Ausgangssignal xsi, sodass das in dem ersten Signalaufbereitungsblock V1 aus dem Sensor-Ausgangssignal xs1 abgeleitete Lokalisierungssignal xp eine einfache und zuverlässige Detektion des Lokalisierungsstroms Ip ermöglicht.

**Fig. 7** beschreibt schematisch das Synchronisationsverhalten zwischen dem Lokalisierungsstrom Ip, einem Effektivwert xseff des von dem zweiten Signalaufbereitungsblock V2 erzeugten Wechselspannungssignals xs (Fig. 1) und einem Effektivwert xs2eff des zweiten Sensor-Ausgangssignals xs2 (Fig. 1).

In dem dargestellten Fallbeispiel erstreckt sich die Messperiode Tm über zwei Perioden Tp des Lokalisierungsstroms Ip.

Die untere Linie stellt den Effektivwert xs2eff des zweiten Sensorausgangssignals xs2 dar, der sich aufgrund einer Änderung des Wechselmagnetfeldes BL (Laststromänderung) sprunghaft während der Messperiode Tm ändert - allerdings ist die Änderung nur so groß, dass keine Magnetfeld-Messbereichsüberschreitung des ersten Stromsensors S1 erfolgt. Um die Detektion des Lokalisierungsstroms Ip, insbesondere durch Störungen bei der Erfassung des teil-kompensierten Magnetfeldes B1 durch den ersten Stromsensor S1 nicht zu gefährden, wird das Wechselspannungssignal xs am Ausgang des zweiten Signalaufbereitungsblocks V2 während der Messperiode Tm unverändert fortgesetzt, dessen Effektivwert xseff also konstant gehalten. Die Änderung des Wechselmagnetfeldes BL während der Messperiode Tm, also der Sprung des Effektivwertes xs2eff des zweiten Sensorausgangssignals xs2, macht sich in dem Effektivwert xseff erst zu Beginn der nächsten Messperiode Tm bemerkbar und wird, da zu Beginn dieser folgenden Messperiode Tm kein veränderter Wert vorliegt, als Effektivwert xseff für diese folgende Messperiode Tm herangezogen.

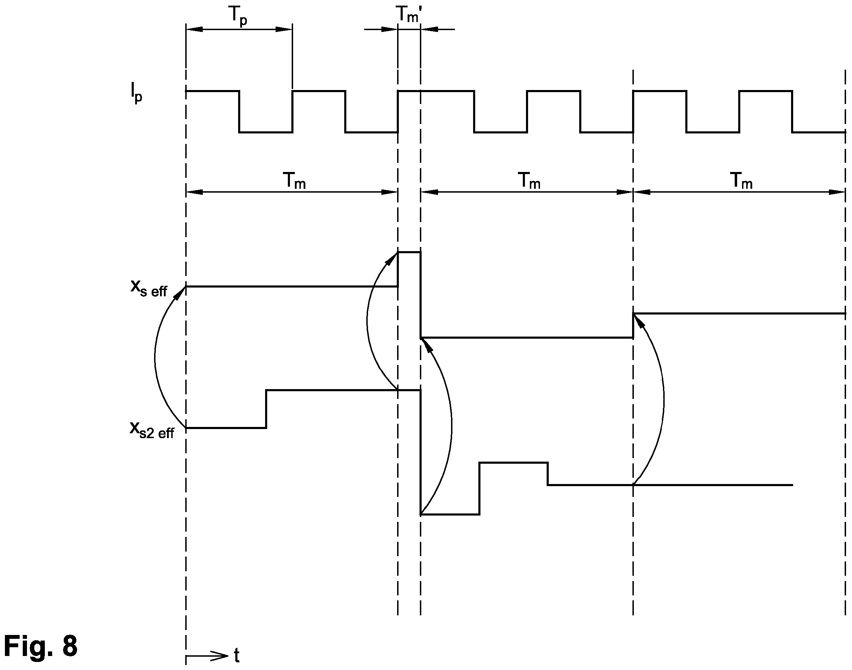

**Fig. 8** zeigt schematisch das Synchronisationsverhalten bei Übersteuerung des ersten Stromsensors S1.

Wird aufgrund einer zu großen Änderung des Wechselmagnetfeldes BL der Magnetfeld-Messbereich des ersten Stromsensors S1 überschritten, so wird die Messperiode Tm' abgebrochen und mit einem angepassten Effektivwert xseff neu gestartet.

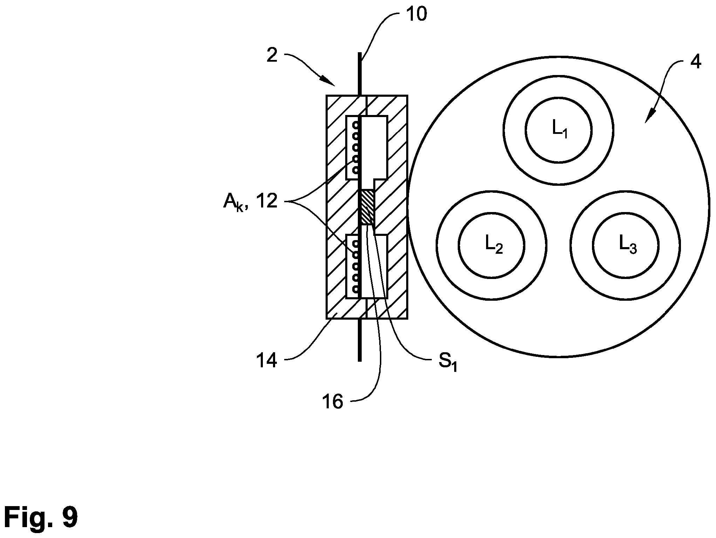

**Fig. 9** zeigt eine Realisierung der erfindungsgemäßen Magnetfeld-Messvorrichtung 2 in schematischer Darstellung.

In Querschnittsdarstellung ist die Lage der Magnetfeld-Messvorrichtung 2 in Bezug auf den zu überprüfenden Leitungsabschnitt 4 gezeigt. Die Magnetfeld-Messvorrichtung 2 besteht aus einer Leiterplatte 10, auf die die Kompensationsspule Ak als Planarspule mit als Leiterbahn 12 ausgeführter Wicklung aufgetragen ist. Die Leiterbahn 12 wird von dem Kompensationsstrom Ik durchflossen und erzeugt ein Kompensations-Magnetfeld Bk, welches in einem Planarkern 14 aus Ferrit geführt wird.

In einem Luftspalt 16 des Planarkerns 14 ist der erste Stromsensor S1 zur Erfassung des Kompensations-Magnetfeldes Bk, des Wechselmagnetfeldes BL und des Gleichtakt-Magnetfelds Bp angeordnet. In axialer Richtung des Leitungsabschnitts 4 und in umfänglich gleicher Position befindet sich (verdeckt) angeordnet der zweite Stromsensor S2, der vorzugsweise auch auf der Leiterplatte 10, aber in einer solchen Entfernung von dem ersten Stromsensor angeordnet ist, dass das von der Kompensationsspule Ak erzeugte Kompensationsmagnetfeld Bk nicht in den Erfassungsbereich des zweiten Stromsensors S2 einwirkt.

## Patentansprüche

1. Magnetfeld-Messvorrichtung (2) zur Erfassung eines Lokalisierungsstroms (Ip) in einem verzweigten Wechselstrom-Stromversorgungssystem, wobei in einem zu prüfenden Leitungsabschnitt (4) des Wechselstrom-Stromversorgungssystems ein Laststrom (IL) mit einer Netzfrequenz fließt und der Lokalisierungsstrom (Ip) eine Grundfrequenz unterhalb der Netzfrequenz aufweist,
mit einer an dem zu prüfenden Leitungsabschnitt anbringbaren Stromsensoranordnung,
**dadurch gekennzeichnet, dass**
die Stromsensoranordnung besteht aus einem ersten Stromsensor (S1), einem zweiten Stromsensor (S2) und einer Kompensationsspule (Ak), die ein in einem Erfassungsbereich des ersten Stromsensors (S1) wirkendes Kompensations-Magnetfeld (Bk) zur Teil-Kompensation eines von dem Laststrom (IL) bewirkten netzfrequenten Wechselmagnetfelds (BL) erzeugt,
und dass die Magnetfeld-Messvorrichtung (2) einen ersten Signalaufbereitungsblock (V1), einen zweiten Signalaufbereitungsblock (V2) und einen Kompensationsblock (Vk) aufweist, wobei
der erste Stromsensor (S1) und der zweite Stromsensor (S2) so anzuordnen sind, dass der erste Stromsensor (S1) neben dem Kompensations-Magnetfeld (Bk) das Wechselmagnetfeld (BL) und ein von dem Lokalisierungsstrom (Ip) bewirktes Gleichtakt-Magnetfeld (Bp) als teil-kompensiertes Magnetfeld (B1) erfasst und der Einfluss des von der Kompensationsspule (Ak) erzeugten Kompensations-Magnetfeldes (Bk) auf den zweiten Stromsensor (S2) vernachlässigbar ist, sodass der zweite Stromsensor (S2) nur das Wechselmagnetfeld (BL) und das von dem Lokalisierungsstrom (Ip) bewirkte Gleichtakt-Magnetfeld (Bp) als resultierendes Magnetfeld (B2) erfasst, wobei
der erste Signalaufbereitungsblock (V1) aus einem von dem ersten Stromsensor (S1) erzeugten ersten Sensor-Ausgangssignal (xs1) ein den Lokalisierungsstrom (Ip) anzeigendes Lokalisierungssignal (xp) erzeugt,
der zweite Signalaufbereitungsblock (V2) aus einem von dem zweiten Stromsensor (S2) erzeugten zweiten Sensor-Ausgangssignal (xs2) ein dem resultierenden Magnetfeld (B2) entsprechendes Wechselspannungssignal (xs) erzeugt und
der dem zweiten Signalaufbereitungsblock (V2) nachgeschaltete Kompensationsblock (Vk) aus dem Wechselspannungssignal (xs) einen Kompensationsstrom (Ik) erzeugt, welcher die Kompensationsspule (Ak) speist und wobei
der zweite Signalaufbereitungsblock (V2) einen Signaleingang zum Empfang eines Synchronisationssignals (xsync) aufweist, um eine vorgegebene Messperiode (Tm), während der eine Detektion des Lokalisierungsstroms (Ip) ausgeführt wird, mit dem Wechselspannungssignal (xs) zu synchronisieren, und wobei
die Stromsensoren (S1, S2) so ausgelegt sind, dass der zweite Stromsensor (S2) gegenüber dem ersten Stromsensor (S1) eine geringere Magnetfeld-Messempfindlichkeit und einen größeren Magnetfeld-Messbereich aufweist, sodass die Teil-Kompensation nur so weit erfolgt, dass das teil-kompensierte Magnetfeld (B1) den Magnetfeld-Messbereich des ersten Stromsensors (S1) nicht überschreitet.

2. Magnetfeld-Messvorrichtung nach Anspruch 1,
**dadurch gekennzeichnet,**
**dass** der zweite Signalaufbereitungsblock (V2) so ausgelegt ist, dass das erzeugte Wechselspannungssignal (xs) während der Messperiode (Tm) unverändert fortgesetzt wird, wobei sich die Messperiode (Tm) über mehrere Perioden (Tp) des Lokalisierungsstroms (Ip) erstreckt.

3. Magnetfeld-Messvorrichtung nach Anspruch 1 oder 2,
**dadurch gekennzeichnet,**
**dass** der zweite Signalaufbereitungsblock (V2) eine Übersteuerungserkennung (11) zum Erzeugen eines Übersteuerungssignals (xov) bei einer Übersteuerung des Magnetfeld-Messbereiches des ersten Stromsensors (S1) aufweist.

4. Magnetfeld-Messvorrichtung nach einem der Ansprüche 1 bis 3 **dadurch gekennzeichnet,**
**dass** der Kompensationsblock (Vk) eine Anpassungsschaltung (12) zum Anpassen des Kompensationsstroms (Ik) und einen Signaleingang zum Empfangen eines von dem zweiten Signalaufbereitungsblock (V2) erzeugten Anpassungssignals (xad) aufweist.

5. Magnetfeld-Messvorrichtung nach einem der Ansprüche 1 bis 4, **dadurch gekennzeichnet,**
**dass** der erste Signalaufbereitungsblock (V1) zur Erzeugung eines Fein-Kompensationssignals (xf) ausgelegt ist, welches dem Kompensationsblock (Vk) zur Fein-Kompensation des Wechselmagnetfelds (BL) zugeführt wird.

6. Magnetfeld-Messvorrichtung nach einem der Ansprüche 1 bis 5, **dadurch gekennzeichnet,**
**dass** die Kompensationsspule (Ak) eine Planarspule ist, deren Wicklung als Leiterbahn auf einer Leiterplatte (10) ausgeführt ist und die einen Planarkern (14) aus Ferrit aufweist.

7. Magnetfeld-Messvorrichtung nach Anspruch 6,
**dadurch gekennzeichnet,**
**dass** der Planarkern (14) konzentrisch einen Luftspalt (16) aufweist, in dem der erste Stromsensor (S1) angeordnet ist.

8. Magnetfeld-Messvorrichtung nach einem der Ansprüche 6 oder 7, **gekennzeichnet durch**
eine Ausführung als eigenständige Baugruppe bestehend aus der Leiterplatte (10) und einem umschließenden Gehäuse oder einer Vergussmasse, wobei auf der Leiterplatte (10) zusätzlich elektronische Bauelemente zur Signalverarbeitung angeordnet sind.

9. Magnetfeld-Messvorrichtung nach einem der Ansprüche 6 bis 8, **dadurch gekennzeichnet, dass**
der zweite Stromsensor (S2) auf der Leiterplatte (10) angeordnet ist oder als separate bauliche Einheit ausgeführt ist.

10. Verwendung einer Magnetfeld-Messvorrichtung nach einem der Ansprüche 3 bis 9,
als Vorrichtung zur Lokalisierungsstrom-Erfassung für ein Isolationsfehlerlokalisierungssystem (IFLS) in einem Wechselstrom-Stromversorgungssystem, wobei das Lokalisierungssignal (xp) an eine Auswerteeinheit (15) des Isolationsfehlerlokalisierungssystems (IFLS) weitergeleitet wird, das Synchronisationssignal (xsync) von dem Isolationsfehlerlokalisierungssystem (IFLS) mitgeteilt wird und das Übersteuerungssignal (xov) dem Isolationsfehlerlokalisierungssystem (IFLS) zugeführt wird.

11. Verfahren zur Erfassung eines Lokalisierungsstroms (Ip) in einem verzweigten Wechselstrom-Stromversorgungssystem, wobei in einem zu prüfenden Leitungsabschnitt (4) des Wechselstrom-Stromversorgungssystems ein Laststrom (IL) mit einer Netzfrequenz fließt und der Lokalisierungsstrom (Ip) eine Grundfrequenz unterhalb der Netzfrequenz aufweist, umfassend die Verfahrensschritte:
Anbringen einer Stromsensoranordnung, bestehend aus einem ersten Stromsensor (S1), einem zweiten Stromsensor (S2) und einer Kompensationsspule (Ak), die ein in einem Erfassungsbereich des ersten Stromsensors (S1) wirkendes Kompensations-Magnetfeld (Bk) zur Teil-Kompensation eines von dem Laststrom (IL) bewirkten netzfrequenten Wechselmagnetfelds (BL) erzeugt, an dem zu prüfenden Leitungsabschnitt derart, dass
der erste Stromsensor (S1) und der zweite Stromsensor (S2) so anzuordnen sind, dass der erste Stromsensor (S1) neben dem Kompensations-Magnetfeld (Bk) das Wechselmagnetfeld (BL) und ein von dem Lokalisierungsstrom (Ip) bewirktes Gleichtakt-Magnetfeld (Bp) als teil-kompensiertes Magnetfeld (B1) erfasst und der Einfluss des von der Kompensationsspule (Ak) erzeugten Kompensations-Magnetfeldes (Bk) auf den zweiten Stromsensor (S2) vernachlässigbar ist, sodass der zweite Stromsensor (S2) nur das Wechselmagnetfeld (BL) und das von dem Lokalisierungsstrom (Ip) bewirkte Gleichtakt-Magnetfeld (Bp) als resultierendes Magnetfeld (B2) erfasst,
Erzeugen eines den Lokalisierungsstrom (Ip) anzeigenden Lokalisierungssignals (xp) aus einem von dem ersten Stromsensor (S1) erzeugten ersten Sensor-Ausgangssignal (xs1) mittels eines ersten Signalaufbereitungsblocks (V1),
Erzeugen eines Wechselspannungssignals (xs) aus einem von dem zweiten Stromsensor (S2) erzeugten zweiten Sensor-Ausgangssignal (xs2) mittels eines zweiten Signalaufbereitungsblocks (V2),
Erzeugen eines Kompensationsstroms (Ik), welcher die Kompensationsspule (Ak) speist, aus dem von dem zweiten Signalaufbereitungsblock (V2) erzeugten Wechselspannungssignal (xs) mittels eines Kompensationsblocks (Vk),
Empfangen eines Synchronisationssignals (xsync) in dem zweiten Signalaufbereitungsblock (V2), um eine vorgegebene Messperiode (Tm), während der eine Detektion des Lokalisierungsstroms (Ip) ausgeführt wird, mit dem Wechselspannungssignal (xs) zu synchronisieren, und wobei
die Stromsensoren (S1, S2) so ausgewählt werden, dass der zweite Stromsensor (S2) gegenüber dem ersten Stromsensor (S1) eine geringere Magnetfeld-Messempfindlichkeit und einen größeren Magnetfeld-Messbereich aufweist, sodass die Teil-Kompensation nur so weit erfolgt, dass das teil-kompensierte Magnetfeld (B1) den Magnetfeld-Messbereich des ersten Stromsensors (S1) nicht überschreitet.

12. Verfahren nach Anspruch 11,
**dadurch gekennzeichnet,**
**dass** das erzeugte Wechselspannungssignal (xs) während der Messperiode (Tm) unverändert fortgesetzt wird, wobei sich die Messperiode (Tm) über mehrere Perioden (Tp) des Lokalisierungsstroms (Ip) erstreckt.

13. Verfahren nach Anspruch 11 oder 12,
**gekennzeichnet durch**
Erzeugen eines Übersteuerungssignals (xov) zur Erkennung einer Übersteuerung des Magnetfeld-Messbereiches des ersten Stromsensors (S1) in dem zweiten Signalaufbereitungsblock (V2).

14. Verfahren nach Anspruch 13,
**gekennzeichnet durch** Anpassen des Kompensationsstroms (Ik) in dem Kompensationsblock (Vk), falls der Kompensationsblock (Vk) ein Anpassungssignal (xad) von dem zweiten Signalaufbereitungsblock (V2) empfängt.

15. Verfahren nach einem der Ansprüche 11 bis 14,
**gekennzeichnet durch**
Erzeugen eines Fein-Kompensationssignals (xf) in dem ersten Signalaufbereitungsblock (V1), welches dem Kompensationsblock (Vk) zur Fein-Kompensation des Wechselmagnetfelds (BL) zugeführt wird.

## Claims

1. A magnetic field measuring device (2) for detecting a localization current (Ip) in a branched AC power supply system, wherein
a load current (IL) having a mains frequency flows through a line section (4) to be tested of the AC power supply system and the localization current (Ip) has a fundamental frequency lower than the mains frequency, the magnetic field measuring device (2) having a current sensor arrangement mountable on the line section to be tested,
**characterized in that**
the current sensor arrangement consists of a first current sensor (S1), a second current sensor (S2) and a compensating coil (Ak), which generates a compensating magnetic field (Bk) acting in a detection range of the first current sensor (S1) and serving to partially compensate a mains-frequency alternating magnetic field (BL) which is caused by the load current (IL),
and **in that** the magnetic field measuring device (2) has a first signal processing block (V1), a second signal processing block (V2) and a compensating block (Vk), the first current sensor (S1) and the second current sensor (S2) being disposed such that, in addition to the compensating magnetic field (Bk), the first current sensor (S1) detects the alternating magnetic field (BL) and a common-mode magnetic field (Bp) caused by the localization current (Ip) as a partially compensated magnetic field (B1) and the impact of the compensating magnetic field (Bk), which is generated by the compensating coil (Ak), on the second current sensor (S2) is negligible, the second current sensor (S2) thus detecting only the alternating magnetic field (BL) and the common-mode magnetic field (Bp) caused by the localization current (Ip) as a resulting magnetic field (B2),
the first signal processing block (V1) generating a localization signal (xp) indicating the localization current (Ip) from a first sensor output signal (xs1) generated by the first current sensor (S1),
the second signal processing block (V2) generating an alternating voltage signal (xs) corresponding to the resulting magnetic field (B2) from a second sensor output signal (xs2) generated by the second current sensor (S2) and
the compensating block (Vk) connected downstream of the second signal processing block (V2) generating a compensating current (Ik), which feeds the compensating coil (Ak), from the alternating voltage signal (xs) and
the second signal processing block (V2) having a signal input for receiving a synchronization signal (xsync) in order to synchronize a specified measuring period (Tm), during which the localization current (Ip) is detected, with the alternating voltage signal (xs), and the current sensors (S1, S2) being designed such that, compared to the first current sensor (S1), the second current sensor (S2) has a lower magnetic field measuring sensitivity and a greater magnetic field measuring range, for which reason the partial compensation occurs only to the extent that the partially compensated magnetic field (B1) does not exceed the magnetic field measuring range of the first current sensor (S1).

2. Magnetic field measuring device according to claim 1, **characterized in that**
the second signal processing block (V2) is designed such that the generated alternating voltage signal (xs) is continued unchanged during the measuring period (Tm), the measuring period (Tm) extending over several periods (Tp) of the localization current (Ip).

3. The magnetic field measuring device according to claim 1 or 2, **characterized in that**
the second signal processing block (V2) has an overload detection (11) for generating an overload signal (xov) in case of an overload of the magnetic field measuring range of the first current sensor (S1).

4. The magnetic field measuring device according to any one of claims 1 to 3,
**characterized in that**
the compensating block (Vk) has an adjustment circuit (12) for adjusting the compensating current (Ik) and a signal input for receiving an adjustment signal (xad) generated by the second signal processing block (V2).

5. The magnetic field measuring device according to any one of claims 1 to 4,
**characterized in that**
the first signal processing block (V1) is designed to generate a fine compensating signal (xf) which is supplied to the compensating block (Vk) for fine compensation of the alternating magnetic field (BL).

6. The magnetic field measuring device according to any one of claims 1 to 5,
**characterized in that**
the compensating coil (Ak) is a planar coil of which the winding is realized as a conducting path on a circuit board (10) and which has a planar core (14) made of ferrite.

7. The magnetic field measuring device according to claim 6, **characterized in that**
the planar core (14) concentrically has an air gap (16) in which the first current sensor (S1) is disposed.

8. The magnetic field measuring device according to any one of claims 6 or 7,
**characterized by**
an embodiment as an independent assembly comprising the circuit board (10) and a surrounding housing or a casting compound, electronic components for signal processing being additionally disposed on the circuit board (10).

9. The magnetic field measuring device according to any one of claims 6 to 8,
**characterized in that**
the second current sensor (S2) is disposed on the circuit board (10) or realized as a separate structural unit.

10. A use of a magnetic field measuring device according to any one of claims 3 to 9,
as a device for detecting a localization current for an insulation fault localization system (IFLS) in an AC power supply system, the localization signal (xp) being transmitted to an evaluation unit (15) of the insulation fault localization system (IFLS), the synchronization signal (xsync) being emitted by the insulation fault localization system (IFLS) and the overload signal (xov) being supplied to the insulation fault localization system (IFLS).

11. A method for detecting a localization current (Ip) in a branched AC power supply system, a load current (IL) having a mains frequency flowing through a line section (4) to be tested of the AC power supply system and the localization current (Ip) having a fundamental frequency lower than the mains frequency, the method comprising the following steps:
mounting a current sensor arrangement consisting of a first current sensor (S1), a second current sensor (S2) and a compensating coil (Ak), which generates a compensating magnetic field (Bk) acting in a detection range of the first current sensor (S1) and serving to partially compensate a mains-frequency alternating magnetic field (BL) which is caused by the load current (IL), on the line section to be tested in such a manner that
the first current sensor (S1) and the second current sensor (S2) are disposed such that, in addition to the compensating magnetic field (Bk), the first current sensor (S1) detects the alternating magnetic field (BL) and a common-mode magnetic field (Bp) caused by the localization current (Ip) as a partially compensated magnetic field (B1) and the impact of the compensating magnetic field (Bk) generated by the compensating coil (Ak) on the second current sensor (S2) is negligible, the second current sensor (S2) thus detecting only the alternating magnetic field (BL) and the common-mode magnetic field (Bp) caused by the localization current (Ip) as a resulting magnetic field (B2),
generating a localization signal (xp) indicating the localization current (Ip) from a first sensor output signal (xs1), which is generated by the first current sensor (S1), by means of a first signal processing block (V1),
generating an alternating voltage signal (xs) from a second sensor output signal (xs2), which is generated by the second current sensor (S2), by means of a second signal processing block (V2),
generating a compensating current (Ik), which feeds the compensating coil (Ak), from the alternating voltage signal (xs), which is generated by the second signal processing block (V2), by means of a compensating block (Vk),
receiving a synchronization signal (xsync) in the second signal processing block (V2) in order to synchronize a specified measuring period (Tm), during which a detection of the localization current (Ip) is detected, with the alternating voltage signal (xs), and
the current sensors (S1, S2) being selected such that, compared to the first current sensor (S1), the second current sensor (S2) has a lower magnetic field measuring sensitivity and a greater magnetic field measuring range, for which reason the partial compensation occurs only to the extent that the partially compensated magnetic field (B1) does not exceed the magnetic field measuring range of the first current sensor (S1).

12. The method according to claim 11,
**characterized in that**
the generated alternating voltage signal (xs) is continued unchanged during the measuring period (Tm), the measuring period (Tm) extending over several periods (Tp) of the localization current (Ip).

13. The method according to claim 11 or 12,
**characterized by**
generating an overload signal (xov) for detecting an overload of the magnetic field measuring range of the first current sensor (S1) in the second signal processing block (V2).

14. The method according to claim 13,
**characterized by**
adjusting the compensating current (Ik) in the compensating block (Vk) in case the compensating block (Vk) receives an adjustment signal (xad) from the second signal processing block (V2).

15. The method according to any one of claims 11 to 14, **characterized by**
generating a fine compensating signal (xf) in the first signal processing block (V1), which is supplied to the compensating block (Vk) for fine compensation of the alternating magnetic field (BL).

## Revendications

1. Dispositif de mesure (2) du champ magnétique pour détecter un courant de localisation (Ip) dans un système d'alimentation électrique en courant alternatif branché, un courant de charge (IL) ayant une fréquence industrielle écoulant dans une section de ligne (4) à être testée du système d'alimentation électrique en courant alternatif et le courant de localisation (Ip) ayant une fréquence fondamentale plus inférieure que la fréquence industrielle, le dispositif de mesure (2) du champ magnétique ayant un ensemble de capteurs de courant montable sur la section de ligne à être testée,
**caractérisé en ce que**
l'ensemble de capteurs de courant consiste en un premier capteur de courant (S1), en un deuxième capteur de courant (S2) et en une bobine de compensation (Ak), qui génère un champ magnétique de compensation (Bk) agissant dans une plage de détection du premier capteur de courant (S1) et servant à compenser partiellement un champ magnétique alternatif (BL) à fréquence industrielle qui est effectué par le courant de charge (IL),
et **en ce que** le dispositif de mesure (2) du champ magnétique a un premier bloc (V1) de traitement de signal, un deuxième bloc (V2) de traitement de signal et un bloc de compensation (Vk),
le premier capteur de courant (S1) et le deuxième capteur de courant (S2) étant disposés de telle manière qu'en plus du champ magnétique de compensation (Bk), le premier capteur de courant (S1) détecte le champ magnétique alternatif (BL) et un champ magnétique (Bp) en mode commun effectué par le courant de localisation (Ip) comme champ magnétique (B1) compensé partiellement et l'impact du champ magnétique de compensation (Bk), qui est généré par la bobine de compensation (Ak), sur le deuxième capteur de courant (S2) est négligeable, le deuxième capteur de courant (S2) donc détectant seulement le champ magnétique alternatif (BL) et le champ magnétique (Bp) en mode commun effectué par le courant de localisation (Ip) comme champ magnétique (B2) résultant,
le premier bloc (V1) de traitement de signal générant un signal de localisation (xp) indiquant le courant de localisation (Ip) d'un premier signal (xs1) de sortie de capteur généré par le premier capteur de courant (S1),
le deuxième bloc (V2) de traitement de signal générant un signal de tension alternative (xs) correspondant au champ magnétique (B2) résultant d'un deuxième signal (xs2) de sortie de capteur généré par le deuxième capteur de courant (S2) et
le bloc de compensation (Vk) relié en en aval du deuxième bloc (V2) de traitement de signal générant un courant de compensation (Ik), qui alimente la bobine de compensation (Ak) en énergie, du signal de tension alternative (xs) et
le deuxième bloc (V2) de traitement de signal ayant une entrée de signal pour recevoir un signal de synchronisation (xsync) afin de synchroniser une période de mesure (Tm) spécifiée, pendant laquelle le courant de localisation (Ip) est détecté, avec le signal de tension alternative (xs), et
les capteurs de courant (S1, S2) étant conçus de telle manière que, en comparaison au premier capteur de courant (S1), le deuxième capteur de courant (S2) a une sensibilité de mesure du champ magnétique plus inférieure et a une plage de mesure du champ magnétique plus grande, pour cette raison la compensation partielle a lieu seulement dans la mesure que le champ magnétique (B1) compensé partiellement n'excède pas la plage de mesure du champ magnétique du premier capteur de courant (S1).

2. Dispositif de mesure du champ magnétique selon la revendication 1, **caractérisé en ce que**
le deuxième bloc (V2) de traitement de signal est conçu de telle manière que le signal de tension alternative (xs) généré est continué de manière inchangée pendant la période de mesure (Tm), la période de mesure (Tm) étendant sur plusieurs périodes (Tp) du courant de localisation (Ip).

3. Dispositif de mesure du champ magnétique selon la revendication 1 ou la revendication 2,
**caractérisé en ce que**
le deuxième bloc (V2) de traitement de signal a une détection de surcharge (11) pour générer un signal de surcharge (xov) en cas d'une surcharge de la plage de mesure du champ magnétique du premier capteur de courant (S1).

4. Dispositif de mesure du champ magnétique selon l'une quelconque des revendications 1 à 3,
**caractérisé en ce que**
le bloc de compensation (Vk) a un circuit d'ajustement (12) pour ajuster le courant de compensation (Ik) et une entrée de signal pour recevoir un signal d'ajustement (xad) généré par le deuxième bloc (V2) de traitement de signal.

5. Dispositif de mesure du champ magnétique selon l'une quelconque des revendications 1 à 4,
**caractérisé en ce que**
le premier bloc (V1) de traitement de signal est conçu pour générer un signal de compensation fine (xf) qui est alimenté au bloc de compensation (Vk) pour une compensation fine du champ magnétique alternatif (BL).

6. Dispositif de mesure du champ magnétique selon l'une quelconque des revendications 1 à 5,
**caractérisé en ce que**
la bobine de compensation (Ak) est une bobine plane dont enroulement est réalisé comme pas de conduction sur un circuit imprimé (10) et qui a un noyau plan (14) en ferrite.

7. Dispositif de mesure du champ magnétique selon la revendication 6, **caractérisé en ce que**
le noyau plan (14) a concentriquement un entrefer (16) dans lequel le premier capteur de courant (S1) est disposé.

8. Dispositif de mesure du champ magnétique selon l'une quelconque des revendications 6 ou la revendication 7,
**caractérisé par**
une réalisation comme ensemble de construction indépendant consistant du circuit imprimé (10) et un boîtier encerclant ou une masse de scellement, des composants électroniques pour le traitement de signal étant disposés de plus sur le circuit imprimé (10).

9. Dispositif de mesure du champ magnétique selon l'une quelconque des revendications 6 à 8,
**caractérisé en ce que**
le deuxième capteur de courant (S2) est disposé sur le circuit imprimé (10) ou est réalisé comme unité structurelle séparée.

10. Utilisation d'un dispositif de mesure du champ magnétique selon l'une quelconque des revendications 3 à 9,
comme dispositif pour détecter un courant de localisation pour un système (IFLS) de localisation de défaut d'isolement dans un système d'alimentation électrique en courant alternatif, le signal de localisation (xp) étant transmis vers une unité d'évaluation (15) du système (IFLS) de localisation de défaut d'isolement, le signal de synchronisation (xsync) étant émis par le système (IFLS) de localisation de défaut d'isolement et le signal de surcharge (xov) étant alimenté au système (IFLS) de localisation de défaut d'isolement.

11. Procédé pour détecter un courant de localisation (Ip) dans un système d'alimentation électrique en courant alternatif branché, un courant de charge (IL) ayant une fréquence industrielle écoulant dans une section de ligne (4) à être testée du système d'alimentation électrique en courant alternatif et le courant de localisation (Ip) ayant une fréquence fondamentale plus inférieure que la fréquence industrielle, le procédé comprenant les étapes suivantes :
monter un ensemble de capteurs de courant consistant en un premier capteur de courant (S1), en un deuxième capteur de courant (S2) et en une bobine de compensation (Ak), qui génère un champ magnétique de compensation (Bk) agissant dans une plage de détection du premier capteur de courant (S1) et servant à compenser partiellement un champ magnétique alternatif (BL) à fréquence industrielle qui est effectué par le courant de charge (IL), sur la section de ligne à être testée de telle manière que
le premier capteur de courant (S1) et le deuxième capteur de courant (S2) sont disposés de telle manière qu'en plus du champ magnétique de compensation (Bk), le premier capteur de courant (S1) détecte le champ magnétique alternatif (BL) et un champ magnétique (Bp) en mode commun effectué par le courant de localisation (Ip) comme champ magnétique (B1) compensé partiellement et l'impact du champ magnétique de compensation (Bk) généré par la bobine de compensation (Ak) sur le deuxième capteur de courant (S2) est négligeable, le deuxième capteur de courant (S2) donc détectant seulement le champ magnétique alternatif (BL) et le champ magnétique (Bp) en mode commun effectué par le courant de localisation (Ip) comme champ magnétique (B2) résultant,
générer un signal de localisation (xp) indiquant le courant de localisation (Ip) d'un premier signal (xs1) de sortie de capteur, qui est généré par le premier capteur de courant (S1), au moyen d'un premier bloc (V1) de traitement de signal,
générer un signal de tension alternative (xs) d'un deuxième signal (xs2) de sortie de capteur, qui est généré par le deuxième capteur de courant (S2), au moyen d'un deuxième bloc (V2) de traitement de signal,
générer un courant de compensation (Ik), qui alimente la bobine de compensation (Ak) en énergie, du signal de tension alternative (xs), qui est généré par le deuxième bloc (V2) de traitement de signal, au moyen d'un bloc de compensation (Vk),
recevoir un signal de synchronisation (xsync) dans le deuxième bloc (V2) de traitement de signal afin de synchroniser une période de mesure (Tm) spécifiée, pendant laquelle le courant de localisation (Ip) est détecté, avec le signal de tension alternative (xs), et
les capteurs de courant (S1, S2) étant choisis de telle manière que, en comparaison au premier capteur de courant (S1), le deuxième capteur de courant (S2) a une sensibilité de mesure du champ magnétique plus inférieure et une plage de mesure du champ magnétique plus supérieure, pour telle raison la compensation partielle a lieu seulement dans la mesure que le champ magnétique (B1) compensé partiellement n'excède pas la plage de mesure du champ magnétique du premier capteur de courant (S1).

12. Procédé selon la revendication 11,
**caractérisé en ce que**
le signal de tension alternative (xs) généré est continu de manière inchangée pendant la période de mesure (Tm), la période de mesure (Tm) étendant sur plusieurs périodes (Tp) du courant de localisation (Ip).

13. Procédé selon la revendication 11 ou la revendication 12, **caractérisé par**
générer un signal de surcharge (xov) pour détecter une surcharge de la plage de mesure du champ magnétique du premier capteur de courant (S1) dans le deuxième bloc (V2) de traitement de signal.

14. Procédé selon la revendication 13,
**caractérisé par**
ajuster le courant de compensation (Ik) dans le bloc de compensation (Vk) en cas que le bloc de compensation (Vk) reçoit un signal d'ajustement (xad) du deuxième bloc (V2) de traitement de signal.

15. Procédé selon l'une quelconque des revendications 11 à 14, **caractérisé par**
générer un signal de compensation fine (xf) dans le premier bloc (V1) de traitement de signal, qui est alimenté au bloc de compensation (Vk) pour la compensation fine du champ magnétique alternatif (BL).
